(19) Europäisches Patentamt
European Patent Office
Office européen des brevets

(11) **EP 1 726 568 B1**

(12) **EUROPEAN PATENT SPECIFICATION**

(45) Date of publication and mention
of the grant of the patent:
**05.09.2012 Bulletin 2012/36**

(51) Int Cl.:
*C01G 23/07* (2006.01)          *H01L 31/04* (2006.01)
*H01M 14/00* (2006.01)

(21) Application number: **05719984.6**

(22) Date of filing: **04.03.2005**

(86) International application number:
**PCT/JP2005/003712**

(87) International publication number:
**WO 2005/087666 (22.09.2005 Gazette 2005/38)**

(54) **TITANIUM OXIDE PARTICLES, PHOTOELECTRIC CONVERTER USING SUCH TITANIUM OXIDE PARTICLES AND METHOD FOR PRODUCING SUCH TITANIUM OXIDE PARTICLES**

TITANOXIDTEILCHEN, PHOTOELEKTRISCHER UMWANDLER DAMIT UND HERSTELLUNGSVERFAHREN DAFÜR

PARTICULES D OXYDE DE TITANE, CONVERTISSEUR PHOTOÉLECTRIQUE UTILISANT DE TELLES PARTICULES D OXYDE DE TITANE ET PROCÉDÉ POUR FABRIQUER DE TELLES PARTICULES D OXYDE DE TITANE

(84) Designated Contracting States:
**AT BE BG CH CY CZ DE DK EE ES FI FR GB GR HU IE IS IT LI LT LU MC NL PL PT RO SE SI SK TR**

(30) Priority: **17.03.2004 JP 2004075641**

(43) Date of publication of application:
**29.11.2006 Bulletin 2006/48**

(73) Proprietor: **Nippon Aerosil Co., Ltd.**
**Shinjuku-ku,**
**Tokyo 163-0913 (JP)**

(72) Inventors:
• **UCHIDA, Satoshi**
**Sendai-shi, Miyagi 9820807 (JP)**
• **SANEHIRA, Yoshitaka**
**Sendai-shi, Miyagi 9820801 (JP)**
• **BRANDL, Paul,**
**c/o NIPPON AEROSIL CO., LTD.**
**Yokkaichi-shi, Mie 5100841 (JP)**

• **OCHIAI, Mitsuru,**
**c/o NIPPON AEROSIL CO., LTD.**
**Tokyo 1630913 (JP)**
• **KONNO, Kazuhisa,**
**c/o NIPPON AEROSIL CO., LTD.**
**Yokkaichi-shi, Mie 5100841 (JP)**
• **SUZUKI, Shigeru,**
**c/o NIPPON AEROSIL CO., LTD.**
**Yokkaichi-shi, Mie 5100841 (JP)**

(74) Representative: **Leman Consulting S.A.**
**Chemin de Précossy 31**
**1260 Nyon (CH)**

(56) References cited:
**WO-A1-03/074426**          **JP-A- 57 123 824**
**JP-A- 2002 261 310**        **JP-A- 2003 252 624**
**US-A1- 2002 018 741**

EP 1 726 568 B1

**Description**

**Field of the Invention**

The present invention relates to a titanium dioxide particle being suitable for dispersing in an electrically-conductive film of a photovoltaic device, a photovoltaic device using the titanium dioxide particle, a manufacturing method of the titanium dioxide particle, and a dye-sensitized solar cell using the photovoltaic device.

**Description of the Conventional Art**

As the conventional manufacturing method of such the titanium dioxide particle, the manufacturing method of a titanium dioxide fine particle by a liquid process, where niobium or tantalum is added to the titanium dioxide particle as a dopant, has been indicated (for example, referring to the Patent Document 1). When the titanium dioxide fine particle is manufactured by hydrolysis, a titanium dioxide precursor is mixed with water in a liquid vessel, heated, and post-treated. The niobium or tantalum is added in the mixing process or the heating process. More particularly, first, the dopant is added by working a compound of niobium or tantalum at the time of the hydrolysis of titanium alkoxide. As the compound of niobium or tantalum, an alkoxide of niobium or tantalum is used. Further, an amine is used as a hydrolysis catalyst of the titanium alkoxide. Next, a mixture containing one or both of the titanium dioxide precursor and a complex formed with the titanium dioxide precursor and ligands and water is heated at from 150 to 300°C in a pressure vessel. As the titanium dioxide precursor, a halogenoid titanium or an orthotitanate ester is used. When the titanium dioxide fine particle manufactured by this method is used, a short circuit current is increased, and the photovoltaic device having excellent photon-to-electron conversion efficiency can be made.

Furthermore, as the other method, the manufacturing method of a titanium dioxide ultrafine particle containing low chlorine and low rutile by a vapor phase method has been indicated (for example, referring to the Patent Document 2). In this manufacturing method, a gas containing titanium tetrachloride and an oxidizing gas are induced into a reaction vessel at from 800 to 1100°C to react these gases, and chlorine is removed from the generated titanium dioxide by, for example, a dry dechlorinating method.

**Summary of the Invention**

However, in the conventional manufacturing method of the titanium dioxide fine particle by the liquid process, which is shown in the Patent Document 1, the fine particle must be always dispersed in a dispersion liquid in order to inhibit agglomeration of the fine particle manufactured by the alkoxide being nano size, and thus there is a problem being difficult to control a solid-liquid ratio or a liquid property, such as pH, etc.

Moreover, in the conventional manufacturing method of the titanium dioxide ultrafine particle containing low chlorine and low rutile by the vapor phase method, which is shown in the Patent Document 2, there is a problem being difficult to handle the removed chlorine.

The object of the present invention is to provide the titanium dioxide particle and the manufacturing method of the same, wherein a primary particle size is uniform, the agglomeration does not occur even if the particle is not dispersed in the dispersion liquid, preservability is excellent, chlorine being difficult to be handled is not generated, and dispersibility to an acidic aqueous solution is excellent.

The another object of the present invention is to provide the photovoltaic device and the dye-sensitized solar cell having high short circuit current density and photon-to-electron conversion efficiency by using the titanium dioxide particle of the present invention.

The invention according to Claim 1 is a titanium dioxide particle having 70 to 95 wt% crystalline anatase, a BET specific surface area being 65 to 120 $m^2$/g, and oil absorption being 70 to 90 ml/100g measured by the method according to JIS K5101. As for this titanium dioxide particle according to Claim 1, the primary particle size is uniform, the agglomeration does not occur, and the dispersibility to an acidic aqueous solution is excellent.

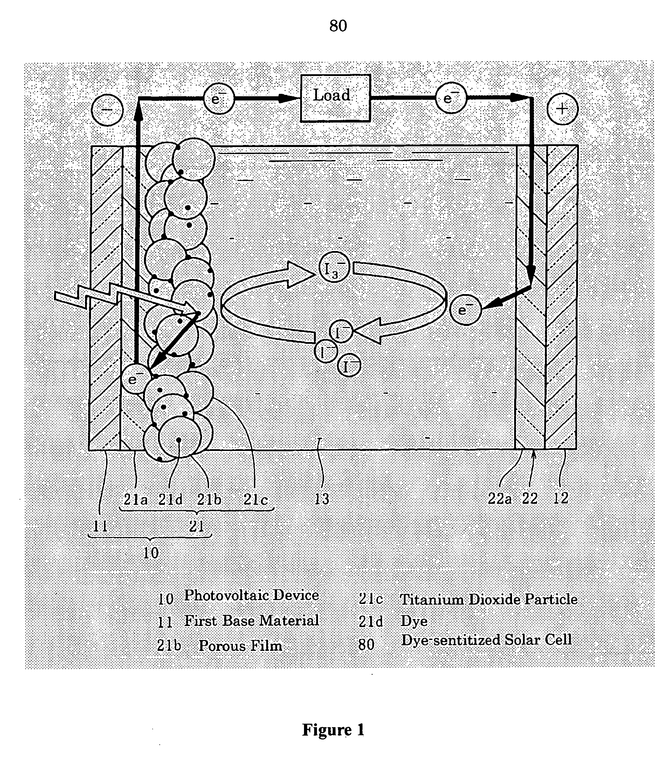

The invention according to Claim 2 is the improved photovoltaic device comprising a light-transmittable base material 11 and a porous film 21b being formed on the base material 11 and absorbing a dye 21 d, as shown in Figure 1.

The characteristic constitution of this photovoltaic device is that the porous film 21 b absorbing the dye 21d contains the titanium dioxide particle 21c having 70 to 95 wt% crystalline anatase, the BET specific surface area being 65 to 120 $m^2$/g, and the oil absorption being 70 to 90 ml/100g measured by the method according to JIS K5101. As for this photovoltaic device according to Claim 2, since the specific surface area per unit volume of the porous film 21b is increased, the amount of the absorbed dye is increased, the short circuit current density of a dye-sensitized solar cell 80 using this photovoltaic device 10 becomes high, and the photon-to-electron conversion efficiency becomes also high.

The invention according to Claim 4 is the dye-sensitized solar cell using the photovoltaic device according to Claim 2 or 3, as shown in Figure 1.

As for the dye-sensitized solar cell according to Claim 4, since the specific surface area per unit volume of the porous film 21b is increased, the amount of the absorbed dye is increased, the short circuit current density becomes high, and the photon-to-electron conversion efficiency becomes also high.

As mentioned above, according to the present invention, since the titanium dioxide particle has the 70 to 95 wt% crystalline anatase, the BET specific surface area being 65 to 120 $m^2/g$, and the oil absorption being 70 to 90 ml/100g measured by the method according to JIS K5101, the primary particle size is uniform, the agglomeration does not occur, and the dispersibility to the acidic aqueous solution is excellent. So, this titanium dioxide particle is suitable for using as an electrode of the dye-sensitized solar cell.

Moreover, when the dye-absorbed porous film is formed on the light-transmittable base material of the photovoltaic device and this dye-absorbed porous film contains the titanium dioxide particle, the specific surface area per unit volume of the porous film is increased. So, the amount of the absorbed dye is increased, the short circuit current density of the dye-sensitized solar cell using this photovoltaic device becomes high, and the photon-to-electron conversion efficiency becomes also high.

Moreover, in the case of manufacturing the titanium dioxide particle by flame-hydrolyzing titanium tetrachloride in the hydrogen burning flame, when the theoretical burning temperature of the flame is set within the range from 400 to 700°C, it is possible to obtain the titanium dioxide particle having the purity of 99.5 % or more, wherein the primary particle size is uniform, the agglomeration does not occur even when the particle is not dispersed in the dispersion liquid, the chlorine being difficult to handle is not generated, and the dispersibility to the acidic aqueous solution is excellent.

Furthermore, as for the dye-sensitized solar cell using this photovoltaic device, since the specific surface area per the unit volume of the porous film is increased, the amount of the absorbed dye is increased, the short circuit current density becomes high, and the photon-to-electron conversion efficiency becomes also high.

## Brief Explanation of Drawings

    **Figure 1:** A sectional constitution view of a dye-sensitized solar cell using a photovoltaic device containing a titanium dioxide particle of the preferred embodiment of the present invention.
    **Figure 2:** A diagram showing a process for manufacturing a titanium dioxide particle by flame-hydrolyzing high purity titanium tetrachloride.
    **Figure 3:** A graph showing a particle size distribution of powders comprising titanium dioxide particles of Example 2 and Comparison example 1.
    **Figure 4:** A graph showing I-V curve characteristic of the dye-sensitized solar cells of Example 3 and Comparison example 2.

## Detailed Description of Preferred Embodiment

Next, the detailed description of the preferred embodiment of the present invention is explained based on the drawings.

The titanium dioxide particle of the preferred embodiment (a titania ($TiO_2$) particle) has the crystalline anatase being 70 to 95 wt%, preferably 75 to 90 wt%, the BET specific surface area being 65 to 120 $m^2/g$, preferably 70 to 100 $m^2/g$, and the oil absorption being 70 to 90 ml/100g, preferably 70 to 85 ml/100g, measured by the method according to JIS K5101. At this time, the reason why the BET specific surface area of the titanium dioxide particle is limited within the range from 65 to 120 $m^2/g$ is that the particle size of the titanium dioxide particle may be increased when the specific surface area is less than 65 $m^2/g$, and the productivity of the titanium dioxide is remarkably decreased when the specific surface area is more than 120 $m^2/g$. Furthermore, the reason why the oil absorption is limited within the range from 70 to 90 ml/100g is that the viscosity of a paste prepared by using the acidic aqueous solution, where the titanium dioxide is dispersed (hereinafter, this paste is said to as an acidic aqueous paste), becomes too low when the oil absorption is less than 70 ml/100g, and the viscosity of the acidic aqueous paste becomes too high when the oil absorption is more than 90 ml/100g.

The manufacturing method of the titanium dioxide particle constituted in this way is explained.

The titanium tetrachloride liquid having high purity is heated and vaporized, and the vaporized titanium tetrachloride liquid is mixed with hydrogen and air to prepare a raw material gas. Further, the raw material gas is flame-hydrolyzed in the flame, in which hydrogen is burned, to manufacture the titanium dioxide particle. In addition, the theoretical burning temperature of the flame is set within the range from 400 to 700°C, preferably from 450 to 600°C. At this time, the reason why the theoretical burning temperature of the flame is set within the range from 400 to 700°C is that the productivity of the titanium dioxide may be remarkably decreased when the temperature is less than 400°C, and the particle size of the manufactured titanium dioxide particle may be increased when the temperature is more than 700°C.

The manufacturing method of the titanium dioxide particle by the above flame hydrolysis is concretely explained.

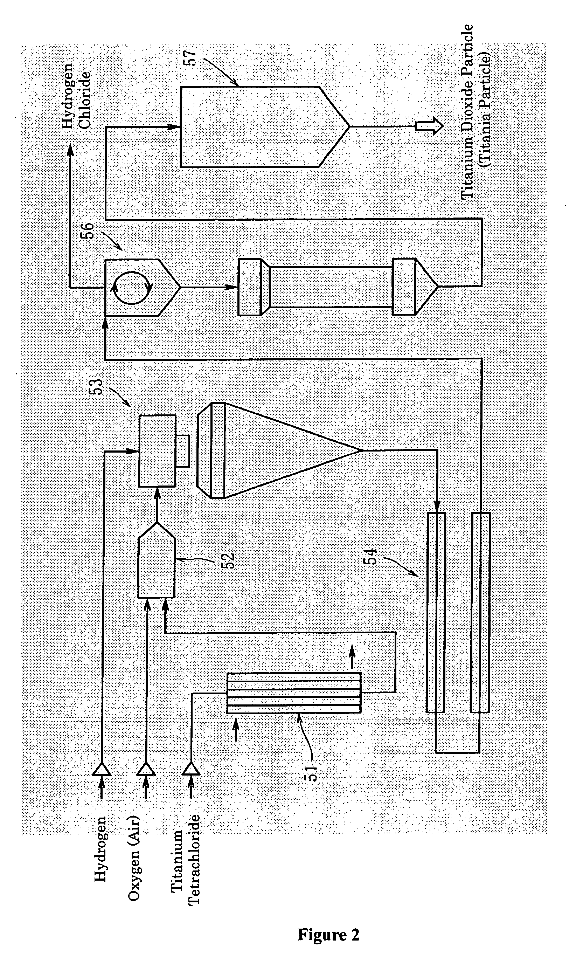

First, the titanium tetrachloride is vaporized with an evaporator 51 to be fed to a mixer 52, and the vaporized titanium tetrachloride is mixed with oxygen (air) in the mixer 52, as shown in Figure 2. Next, the mixed gas is fed to a burner 53 together with hydrogen to be burned. That is, the titanium dioxide particle (the titania particle) and a by-product (hydrogen chloride) are generated by flame-hydrolyzing the titanium tetrachloride with the burner 53. Further, the titanium dioxide particle and the by-product are cooled in a cooling zone 54, and hydrogen chloride being the by-product is removed by a hydrogen chloride separator 56. The dechlorinated titanium dioxide particle is stored in a storage silo 57. In addition, the particle size of the generated titanium dioxide particle can be controlled by changing the conditions of flame-hydrolysis, for example, the feeding amount of the titanium tetrachloride, oxygen (air), or hydrogen.

A manufacturing method of a photovoltaic device 10 using the titanium dioxide particle is explained.

First, a first electrically-conductive film 21a is formed on a first base material 11 (Figure 1). Next, the acidic aqueous paste is coated on the first electrically-conductive film 21a to be dried. This first electrically-conductive film 21a is formed on an one side, both sides, or whole surface of the first base material 11 by a vapor deposition method, a sputtering method, an ion plating method, a hydrolysis or the like. As the first base material 11, a light-transmittable glass plate or a light-transmittable and flexible plastic film can be preferably used. As the first electrically-conductive film 21 a, a film in which fluorine is doped in tin oxide (FTO) or a film in which a little amount of tin oxide is mixed with indium oxide (ITO film) can be preferably used. It is preferable that the surface resistivity of the first electrically-conductive film 21 a is 5 to 15Ω/□.

Moreover, the acidic aqueous paste is prepared by the following processes. First, the titanium dioxide particle manufactured by the above-mentioned flame-hydrolysis is mixed with an acidic aqueous solution of nitric acid, hydrochloric acid, sulfuric acid or the like to prepare the acidic aqueous solution in which the titanium dioxide particle is dispersed. The pH of this acidic aqueous solution is preferably 3 or less. The reason why the pH of the acidic aqueous solution is 3 or less is that an interface potential of a titanium dioxide particle 21c is controlled in this condition to increase the dispersibility of the titanium dioxide particle 21c. Next, a thickener, a dispersant or the like is added to this acidic aqueous solution to be uniformly mixed to prepare the acidic aqueous paste. As the thickener, glycols such as a polyethylene glycol or the like can be used. As the dispersant, acetylacetone or Triton-X100 (an alkylphenoxypolyethylene glycol type nonionic surfactant) can be used. The reason why the polyethylene glycol is added as the thickener is as follows. That is, the viscosity of the acidic aqueous paste can be increased to form the thick film, and the polyethylene glycol is transpired during the heating of the acidic aqueous paste and thus a communicative connection hole penetrating from the surface to the back surface of the porous film 21b containing the titanium dioxide particle 21c can be formed. In addition, an adhesive strength of the porous film 21b to the first electrically-conductive film 21 a can be increased. When the surfactant such as Triton-X100 or the like is used as the dispersant, there is an advantage that a residual component does not remain after heating.

Next, the forming method of the porous film 21b is explained. When the glass plate is used as the first base material 11, the porous film 21b is formed on the first electrically-conductive film 21a by coating the above-mentioned acidic aqueous paste on the first electrically-conductive film 21 a of the first base material 11. In this case, the coating is carried out by a doctor-blade method, a squeegee method, a spin coat method, a screen printing method or the like. After drying, the coated base material is took into an electric furnace, kept and burned at 300 to 600°C for 30 to 90 minutes in an atmosphere. The porous film 21b constitutes a working electrode 21 together with the first electrically-conductive film 21a and the dye 21d being mentioned after. The reason why the burning temperature is limited within the range from 300 to 600°C is as follows, that is, when the temperature is less than 300°C, an organic additive which cannot be completely burned may be remained to prevent the absorption of the dye, and the high photovoltaic property cannot be obtained since the titanium dioxide particle itself is not burned sufficiently. Further, when the temperature is more than 600°C, there is a problem that the first base material 11 is softened to cause the trouble to make a working electrode 21. Moreover, the reason why the burning time is limited within the range from 30 to 90 minutes is as follows, that is, when the time is less than 30 minutes, an inferior sintering may be caused, and when the time is more than 90 minutes, the specific surface area may be decreased since the growth of the particle is too advanced. Moreover, when the flexible plastic film (for example, a polyethylene terephthalate film) is used as the first base material, the porous film is formed by coating the acidic aqueous paste on the first electrically-electrically-conductive film of the first base material, carrying out a press forming if necessary, irradiating a microwaves to form the porous film on the first electrically-conductive film 21 a, wherein the coating is carried out by a squeegee (applicator) method, a screen printing method, an electrodeposition method, a spray method, DJP (a direct jet printing) method or the like.

Next, the first base material 11, in which the porous film 21b is made on the first electrically-conductive film 21a, is dipped in a dye solution to fix the dye 21d to the porous film 21b by absorbing. As the dye 21d, an organic dye showing a photoelectric effect is preferable other than a ruthenium complex. More particularly, a methine dye, a xanthene dye, a porphyrin dye, a phthalocyanine dye, an azo dye, a coumarin dye or the like can be preferably used, and the mixing dye comprising one or more kinds selected from the group consisting of these dyes can be also preferably used as the photovoltaic material. When the ruthenium complex is used as the dye 21 d, the ruthenium complex is dissolved with a single solvent, such as acetonitrile, t-BuOH, ethanol or the like, or a mixed solvent of these solvents to prepare the dye solution, and the concentration of the dye solution is prepared to 5 x $10^{-4}$ mol. Further, the dipping of the first base material 11 in the dye solution is carried out at the room temperature for about 20 hours in general. At this time, although the dipping time of the first base material 11 in the dye solution is about 20 hours, the dipping time can be reduced about 5 minutes at the shortest by heating and carbonizing the dye solution at near a boiling point. In considering the film thickness of the titanium dioxide particle, the damage to the electrode or the like, it can be prepared so as to have the amount of the absorbed dye to the maximum by taking a suitable operation temperature in each case. Furthermore, the surface of the porous film 21b absorbed with the dye is washed and dried. Thereby, the photovoltaic device 10 can be made.

As for the photovoltaic device 10 being produced by this way, since the much amount of the dye is absorbed per unit volume and unit area, the short circuit current density of the dye-sensitized solar cell 80 using this photovoltaic device 10 becomes high, and thus the photon-to-electron conversion efficiency becomes high.

Next, the manufacturing method of the dye-sensitized solar cell 80 using the photovoltaic device 10 is explained.

A counter electrode 22 is made by forming a second electrically-conductive film 22a on a second base material 12. The second electrically-conductive film 22a is formed on an one side, both sides, or whole surface of the second base material 12 by a vapor deposition method, a sputtering method, a ion plating method, hydrolysis or the like. As the second base material, a glass plate or a flexible plastic film can be preferably used. As the second electrically-conductive film 22a, a platinum foil, a film in which fluorine is doped in tin oxide (FTO), or a film in which a little amount of tin oxide is mixed with indium oxide (ITO film) can be preferably used. Moreover, an electrolyte solution 13 is stored between the working electrode 21 and the counter electrode 22, wherein the working electrode 21 of the first base material 11 and the counter electrode 22 of the second base material 12 are countered with predetermined interval. The electrolyte solution 13 is prepared by mixing a support electrolyte, a redox pair, and a single solvent or a mixed solvent of alcohols (ethanol, t-butanol) or nitriles (acetonitrile, methoxyacetonitrile, 3-methoxypropionitrile), wherein the support electrolyte comprises cations such as a lithium ion or the like and anions such as a chlorine ion or the like and the redox pair is an iodine-iodine compound, a bromine-bromine compound or the like, which is existed in the support electrolyte. In addition, in order to keep the interval between the working electrode 21 of the first base material 11 and the counter electrode 22 of the second base material 12 with the predetermined value, a spacer made with a resin film having a thickness of 10 to 30$\mu$m (which is not shown in the drawings) is placed between the working electrode 21 and the counter electrode 22. Further, in order to prevent leakage of the electrolyte solution 13, and an electric insulation adhesive such as an epoxy resin or the like is coated on the periphery areas between the working electrode 21 and the counter electrode 22, and is cured. Thereby, the dye-sensitized solar cell 80 can be made.

As for the dye-sensitized solar cell 80 being made by this way, since the much amount of the dye is absorbed per unit volume and unit area, the short circuit current density becomes high, and thus the photon-to-electron conversion efficiency becomes high.

## Examples

Next, examples of the present invention are concretely explained with comparison examples.

## Example 1

A titanium dioxide particle was made by mixing a raw material gas, introducing the mixed raw material gas into a burner 53 of a flame hydrolysis apparatus of Figure 2, and flame-hydrolyzing, wherein the raw material gas was mixed so as to have a flow rate of titanium tetrachloride gas of 110 kg/hour, a flow rate of hydrogen gas of 30 Nm$^3$/hour, and a flow rate of air of 600 Nm$^3$/hour. This titanium dioxide particle was shown as Example 1. In addition, the theoretical burning temperature of the flame in the flame hydrolysis was 510°C.

## Example 2

A titanium dioxide particle was made by mixing a raw material gas, introducing the mixed raw material gas into a burner 53 of a flame hydrolysis apparatus of Figure 2 and flame-hydrolyzing it, wherein the raw material gas was mixed so as to have a flow rate of titanium tetrachloride gas of 100 kg/hour, a flow rate of hydrogen gas of 27 Nm$^3$/hour, and a flow rate of air of 660 Nm$^3$/hour. This titanium dioxide particle was shown as Example 2. In addition, the theoretical burning temperature of the flame in the flame hydrolysis was 450°C.

### Comparison example 1

A titanium dioxide particle was made by mixing a raw material gas, introducing the mixed raw material gas into a burner 53 of a flame hydrolysis apparatus of Figure 2, and flame-hydrolyzing it, wherein the raw material gas was mixed so as to have a flow rate of titanium tetrachloride gas of 120 kg/hour, a flow rate of hydrogen gas of 33 $Nm^3$/hour, and a flow rate of air of 500 $Nm^3$/hour. This titanium dioxide particle was shown as Comparison example 1. In addition, the theoretical burning temperature of the flame in the flame hydrolysis was 720°C.

### Comparison test 1 and Evaluation

The containing ratio (wt%) of crystalline anatase, the BET specific surface area ($m^2$/g), and oil absorption (ml/100g) of the titanium dioxide particles of Example 1, Example 2 and Comparison example 1 were measured. These results were shown in Table 1 together with each flow rate of titanium tetrachloride gas, hydrogen gas and air, and each theoretical burning temperature of the flame. In addition, the containing ratio of the anatase crystalline contained in the titanium dioxide particle was measured from the results of powder X-ray analysis. Moreover, the BET specific surface area of the titanium dioxide particle was obtained by absorbing gas molecules (nitrogen molecules) having a publicly known occupation area on the surface of the titanium dioxide particle, and measuring the absorbed amount of the gas molecules. Further, the oil absorption was measured by the method according to JIS K5101. More particularly, an oil absorption A (ml/100g) was determined, by putting 2.00g of the titanium dioxide particle on a glass plate, dropping a boiled linseed oil little by little from a micro view let onto the glass plate, well mixing it with a regular metal turner, finishing the mixing when the mixture of the oil and the titanium dioxide particle becomes putty-like to have moldability, measuring the amount of the linseed oil at this time, and calculating the oil absorption A by using the following formula (1)

$$A = (V/2.00) \times 100 \qquad (1).$$

**Table 1**

| | Flow Rate of Raw Material Mixed Gas | | | Theoretical Burning Temperature of Flame (°C) | Containing Ratio of Crystalline Anatase (wt%) | BET Specific Surface Area ($m^2$/g) | Oil Absorption (ml/100g) |
|---|---|---|---|---|---|---|---|
| | Titanium Tetrachloride (kg/h) | Hydrogen ($Nm^3$/h) | Air ($Nm^3$/h) | | | | |
| Example 1 | 110 | 30 | 600 | 510 | 88 | 73 | 71 |
| Example 2 | 100 | 27 | 660 | 450 | 87 | 86 | 78 |
| Comparison Example 1 | 120 | 33 | 500 | 720 | 81 | 51 | 65 |

Clearly from Table 1, although the BET specific surface area of Comparison example 1 was small, that is, 51 $m^2$/g, the BET specific surface areas of Examples 1 and 2 were large, that is, 73 $m^2$/g and 86 $m^2$/g. Moreover, although there was low oil absorption of Comparison example 1, that is, 65ml/100g, there were much oil absorptions of Examples 1 and 2, that is, 71ml/100g and 78ml/100g. Therefore, it was found out that the viscosity of the acidic aqueous solution was suitable.

### Comparison test 2 and Evaluation

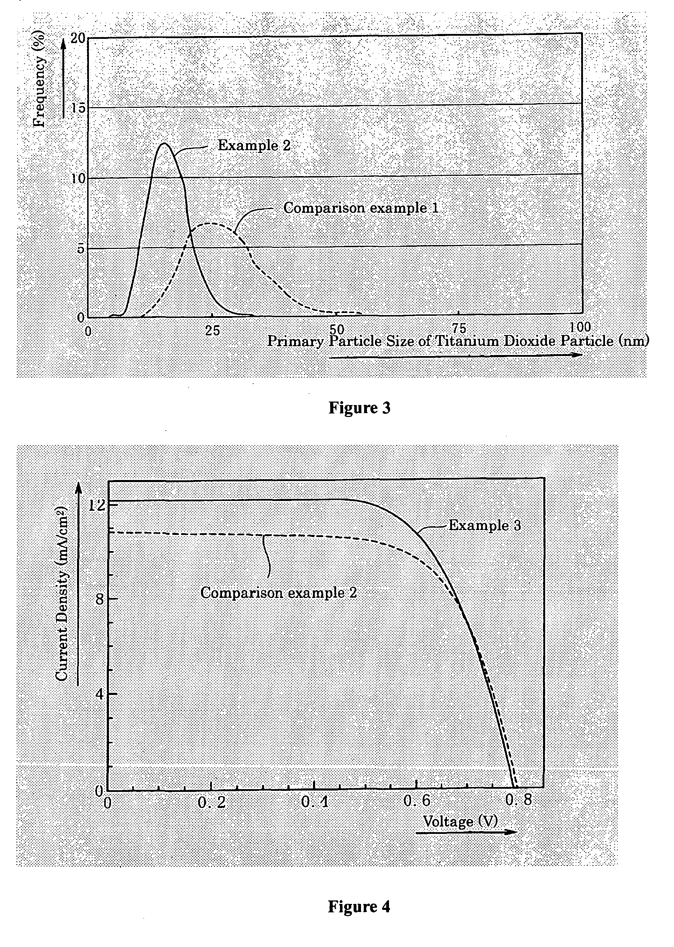

A particle size distribution of a powder comprising the titanium dioxide particles of Example 2 and Comparison example 1 was measured. The measurement was carried out by photographing the powder comprising the titanium dioxide particle by an electron microscope, counting every one number of particles from the photography, and measuring the particle size distribution of the primary particle. These results were shown in Figure 3.

Clearly from Figure 3, it was found that a particle size distribution curve of the powder comprising the titanium dioxide particle of Example 2 was sharper than that of Comparison example 1, and the primary particle of the titanium dioxide particle of Example 2 was uniform rather than that of Comparison example 1.

### Example 3

First, 2.1g of the powder comprising the titanium dioxide particle of Example 2 was mixed with 4.9g of nitric acid water (pH : 0.7) to prepare the acidic aqueous solution in which the titanium dioxide particle was dispersed. Next, 0.21g of acetylacetone and 0.105g of polyethylene glycol (an average molecular weight : 500,000) were mixed with the acidic aqueous solution, in which the titanium dioxide particle was dispersed, to prepare the acidic aqueous paste. This acidic aqueous paste was coated on the first electrically-conductive film 21a on the first base material 11 in the shape of a square where the length and width were 5mm respectively. The first base material 11 having the first electrically-conductive film 21a was a glass plate made by Nippon Sheet Glass Co. Ltd., wherein the first electrically-conductive film 21a, i.e., the film where fluorine was doped to tin oxide, was vapor-deposited on the one side of the glass plate, and the surface resistivity of the first electrically-conductive film 21a was 5 to $15\Omega/\square$. Next, the porous film 21b was made by taking the first base material 11 having the first electrically-conductive film 21 a, which was coated with the acidic aqueous paste, into the electric furnace, keeping it at 500°C under an atmosphere for 30 minutes to be calcined, and making the porous film 21b containing the titanium dioxide particle 21c c on the first electrically-conductive film 21a. Further, Ruthenium535-bisTBA (made by Solaronix Company) was used as the dye 21d, and the dye 21d was dissolved with the mixed solvent of acetonitrile and t-BuOH, to make the dye solution having the dye concentration being adjusted to $5\times10^{-4}$ mol. The dye 21d was absorbed to the porous film 21b by dipping the first base material 11 in this dye solution for 12 hours to be fixed. The surface of the porous film 21b absorbed with the dye 21d was washed with acetonitrile and dried. Thereby, the photovoltaic device 10 was made, where the working electrode 21 consisting of the first electrically-conductive film 21 a, porous film 21b and the dye 21d, was formed on the first base material 11.

On the other hand, the counter electrode 22 was made by vaporizing the second electrically-conductive film 22a of platinum foil having the thickness of 0.1 $\mu$m on the one side of the second base material 12 comprising the glass plate. As the electrolyte solution 13, a methoxyacetonitrile solution was used, wherein the solution was prepared by mixing 0.1 mol of lithium iodide, 0.05 mol of iodine, 0.5 mol of 4-t-butyl pyridine and 0.6 mol of 1-propyl-2, 3-dimethylimidazolium iodide. Next, a spacer made with a resin film having the thickness of 20$\mu$m (which is not shown in the drawings) was placed between the working electrode 21 and the counter electrode 22 and the electrolyte solution 13 was enclosed between the both electrodes 21 and 22, wherein the spacer was formed with a himilan film (made by Du Pont-Mitsui Polychemicals Co. Ltd.). Then, the dye-sensitized solar cell 80 was made and shown as Example 3.

### Comparison example 2

The dye-sensitized solar cell was made like Example 3 excepting that the acidic aqueous paste was prepared by mixing 2.1g of the powder comprising the titanium dioxide particle of Comparison example 1 with 4.9g of the nitric acid water (pH:0.7) to prepare the acidic aqueous solution, and mixing 0.21g of acetylacetone and 0.105g of polyethylene glycol (the average molecular weight : 500,000) with this acidic aqueous solution, in which the titanium dioxide particle was dispersed. The dye-sensitized solar cell was shown as Comparison example 2.

### Comparison test 3 and Evaluation

The I-V curve characteristic of the dye-sensitized solar cells of Example 3 and Comparison example 2 were measured respectively by using a 300W solar simulator (made by Oriel Company) as a light source, irradiating light so as to have the irradiation light amount of 100 mW/cm$^2$ [AM (Air/Mass) 1.5G], and using a potentiostud (HSV-100F made by Hokuto-denko Co. Ltd.). These results were shown in Figure 4.

Clearly from Figure 4, although the short circuit current density of the dye-sensitized solar cell of Comparison example 2 was low, that is, 10.9 mA/cm$^2$, the short circuit current density of the dye-sensitized solar cell of Example 3 was high, that is, 12.2 mA/cm$^2$.

Moreover, the photon-to-electron conversion efficiency $\eta$ (%) of the dye-sensitized solar cells of Example 3 and Comparison example 2 was measured respectively. The photon-to-electron conversion efficiency $\eta$ (%) was calculated from the following formula (1) using Voc (an open-circuit voltage value), Isc (a short circuit current value), ff (a filter factor value), L (irradiation light amount: mW/cm$^2$), and S (an area of the porous film: cm$^2$).

$$\eta = (Voc\times Isc\times ff\times100)/(L\times S) \qquad (1)$$

As the result, although the photon-to-electron conversion efficiency of Comparison example 2 was low, that is, 5.56%, the photon-to-electron conversion efficiency of Example 3 was high, that is, 6.21 %.

## EP 1 726 568 B1

### References

Patent Document 1: Japanese Patent Laid Open No. 2003-252624 (Claim 1, Paragraph [0006], [0007]).
Patent Document 2: WO 03/074426 (Claim 11, 17, 18).

### Claims

1. A titanium dioxide particle having 70 to 95 % by weight crystalline anatase, a BET specific surface area being 65 to 120 m$^2$/g, and oil absorption being 70 to 90 ml/100g measured by the method according to JIS K5101.

2. A photovoltaic device comprising a light-transmittable base material (11) and a porous film (21 b) formed on the base material and absorbing a dye (21 d),
wherein said porous film (21b) absorbing said dye (21d) contains the titanium dioxide particle (21c) having 70 to 95 % by weight crystalline anatase, a BET specific surface area being 65 to 120 m$^2$/g, and oil absorption being 70 to 90 ml/100g measured by the method according to JIS K5101.

3. A photovoltaic device according to claim 2, wherein the base material (11) is a glass plate or a flexible plastic film.

4. A dye-sensitized solar cell using a photovoltaic device according to claim 2 or claim 3.

### Patentansprüche

1. Titandioxidteilchen mit 70 bis 95 Gew.-% Kristallanatase, wobei ein BET-spezifischer Oberflächenbereich 65 bis 120 m2/g beträgt und die Ölabsorption 70 bis 90 ml/100g, gemessen mit dem Verfahren nach JIS K5101.

2. Photovoltaikanlage mit lichtdurchlässigem Basismaterial (11) und einer porösen Folie (21 b) auf dem Basismaterial, die einen Farbstoff (21 d) absorbiert, wobei die poröse Folie (21 b), die besagten Farbstoff (21d) absorbiert, das Titandioxidteilchen (21 c) enthält, das besagten Farbstoff (21 d) absorbiert, wobei das Titandioxidteilchen (21 c) 70 bis 95 Gew.-% Kristallanatase enthält, wobei ein BET-spezifischer Oberflächenbereich 65 bis 120 m2/g beträgt und die Ölabsorption 70 bis 90 ml/100g, gemessen mit dem Verfahren nach JIS K5101.

3. Photovoltaikanlage nach Anspruch 2, wobei das Basismaterial (11) eine Glasscheibe oder eine flexible Kunststofffolie ist.

4. Farbstoff-Solarzelle unter Verwendung einer Photovoltaikanlage nach Anspruch 2 oder Anspruch 3.

### Revendications

1. Particule de dioxyde de titane ayant 70 à 95 % en poids d'anatase cristalline, une surface spécifique de BET de 65 à 120 m$^2$/g, et une absorption d'huile de 70 à 90 ml/100g, mesurée selon la méthode conforme à JIS K5101.

2. Dispositif photovoltaïque comprenant une matière de base transmettant la lumière (11) et une pellicule poreuse (21 b) formée sur la matière de base et absorbant un colorant (21 d), où ladite pellicule poreuse (21 b) absorbant ledit colorant (21 d) contient la particule de dioxyde de titane (21 c) absorbant ledit colorant (21d), la particule de dioxyde de titane (21c) ayant de 70 à 95% en poids d'anatase cristalline, une surface spécifique de BET de 65 à 120 m$^2$/g, et une absorption d'huile de 70 à 90 ml/100g, mesurée selon la méthode conforme à JIS K5101.

3. Dispositif photovoltaïque selon la revendication 2, où la matière de base (11) est une plaque de verre ou une pellicule plastique flexible.

4. Cellule à pigment photosensible utilisant un dispositif photovoltaïque selon la revendication 2 ou la revendication 3.

80

| 10 | Photovoltaic Device | 21c | Titanium Dioxide Particle |
| 11 | First Base Material | 21d | Dye |
| 21b | Porous Film | 80 | Dye-sentitized Solar Cell |

**Figure 1**

**Figure 2**

**Figure 3**

**Figure 4**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003252624 A

- WO 03074426 A